Europäisches Patentamt

(19) European Patent Office

Office européen des brevets

(11) **EP 1 018 166 B1**

(12) **EUROPÄISCHE PATENTSCHRIFT**

(45) Veröffentlichungstag und Bekanntmachung des Hinweises auf die Patenterteilung:
**22.09.2004   Patentblatt 2004/39**

(51) Int Cl.⁷: $H01L\ 31/048$, $H01L\ 31/18$, $B32B\ 31/00$

(21) Anmeldenummer: **99931217.6**

(22) Anmeldetag: **30.06.1999**

(86) Internationale Anmeldenummer:
**PCT/EP1999/004505**

(87) Internationale Veröffentlichungsnummer:
**WO 2000/002257 (13.01.2000 Gazette 2000/02)**

(54) **Verfahren zur Herstellung eines fotovoltaischen Moduls**

Method for producing a photovoltaic module

Procédé de fabrication d'un module photovoltaique

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **03.07.1998  EP 98112319**

(43) Veröffentlichungstag der Anmeldung:
**12.07.2000   Patentblatt 2000/28**

(73) Patentinhaber:
• **ISOVOLTA AG**
  **2355 Wiener Neudorf (AT)**
• **Fraunhofer-Gesellschaft zur Förderung der angewandten Forschung e.V.**
  **80686 München (DE)**

(72) Erfinder:
• **PLESSING, Albert**
  **8302 Brunn 28 (AT)**
• **LANGOWSKI, Horst-Christian**
  **D-85406 Zolling (DE)**

• **MOOSHEIMER, Ulrich**
  **D-85411 Hohenkammer (DE)**

(74) Vertreter: **Dungler, Karin et al**
**c/o Patentanwälte**
**Dipl.-Ing. Manfred Beer und**
**Dipl.-Ing. Reinhard Hehenberger**
**Postfach 264**
**1071 Wien (AT)**

(56) Entgegenhaltungen:
**WO-A-92/06847          WO-A-94/29106**
**WO-A-97/36334          DE-C- 19 611 410**
**US-A- 4 433 200**

• **PATENT ABSTRACTS OF JAPAN vol. 095, no. 006, 31. Juli 1995 (1995-07-31) & JP 07 074378 A (MITSUI TOATSU CHEM INC), 17. März 1995 (1995-03-17)**
• **PATENT ABSTRACTS OF JAPAN vol. 098, no. 005, 30. April 1998 (1998-04-30) & JP 10 025357 A (DAINIPPON PRINTING CO LTD), 27. Januar 1998 (1998-01-27)**

## Beschreibung

Die Erfindung betrifft ein Verfahren zur Herstellung eines fotovoltaischen Moduls in Form eines Laminates, bestehend aus einem Solarzellensystem als Kernschicht sowie beidseitig an diese angebrachten Einkapselungsmaterialien, wobei zumindest ein Einkapselungsmaterial aus einer Siegelschicht und einer Barriereschicht besteht.

Stand der Technik

Fotovoltaische Module dienen zur elektrischen Energieerzeugung aus Sonnenlicht. Die Energieerzeugung erfolgt dabei durch das Solarzellensystem, welches vorzugsweise durch Siliziumzellen ausgebildet ist. Diese sind jedoch mechanisch nur gering belastbar, so dass sie beidseitig mit Einkapselungsmaterialien umhüllt werden müssen. Als Einkapselungsmaterialien dienen beispielsweise ein oder mehrere Schichten aus Glas und/oder Kunststofffolien und/oder Kunststofffolienverbunden.

Kunststofffolienverbunde, bestehend im wesentlichen aus Polyvinylfluorid (PVF) und Polyethylenterephthalat (PET), werden von der Anmelderin unter der Bezeichnung ICOSOLAR produziert und in einem gemäß der WO-A1-94/29106 geoffenbarten Vakuumlaminierverfahren zur Herstellung von fotovoltaischen Modulen eingesetzt. Das Solarzellensystem ist in diesen Modulen nicht nur gegen mechanische Beschädigungen sondern auch gegen Witterungseinflüsse, insbesondere gegen Wasserdampf geschützt. Als Barriereschicht gegenüber Wasserdampf ist im ICOSOLAR-Folienverbund eine Zwischenschicht aus Aluminium vorgesehen. Diese hat jedoch den Nachteil, dass sie in Verbindung mit dem Solarzellensystem elektrisch leitend ist, so dass unerwünschte Fremdströme im fotovoltaischen Modul entstehen.

Gemäß der WO-A1 97/36334 und der DE-C1 19611410 wird eine Barriereschicht, bestehend aus einem Glassubstrat, auf welchem anorganische Oxide durch chemische Dampfphasenabscheidung (CVD-Chemical Vapor Deposition) abgeschieden worden sind, vorgeschlagen. Bedingt durch das Substrat und die Art der Dampfabscheidung sind jedoch sowohl der Einsatz der Verfahrensendprodukte als auch die Durchführung des Verfahrens limitiert.

Zwar beschreiben die Dokumente JP-A-10025357 und JP-A-07074378 einen Solarzellen-Modulaufbau unter Verwendung flexibler Trägermaterialien, wie Kunststofffolien, wobei eine inorganische Oxidschicht als Barriereschicht abgeschieden wird jedoch ist die offenbarte Dampfabscheidung der Oxidschicht insoferne aufwendig, als diese unter Ablauf chemischer Reaktionen mit relativ hohem Energieverbrauch, sogenannte CVD (chemical vapour desposition) -Verfahren, erfolgt.

Darstellung der Erfindung

Aufgabe der vorliegenden Erfindung ist es, ein Verfahren zur Herstellung eines fotovoltaischen Moduls bereitzustellen, welches einerseits leicht durchführbar ist und mit welchem anderseits ein fotovoltaischer Modul erzeugt wird, welcher die geforderten Barriereeigenschaften, insbesondere gegenüber Wasserdampf aufweist.

Erfindungsgemäß wird ein Verfahren der eingangs genannten Art vorgeschlagen, welches dadurch gekennzeichnet ist, dass die Barriereschicht (6) aus einer Kunststofffolie oder einem Kunststofffolienverbund gebildet wird, auf welcher(m) an der dem Solarzellensystem (2) zugewandten Seite eine anorganische Oxidschicht (7) durch Dampfabscheidung im Vakuum unter Anwendung von Elektronenstrahlung hergestellt wird.

Vorteilhafterweise wird zur Verbesserung der Haftung zwischen Kunststofffolienoberfläche und anorganischer Oxidschicht die Oberfläche der Kunststofffolie in einem Plasma aus Sauerstoffgas vorbehandelt.

Ein weiterer Vorteil des erfindungsgemäßen Verfahrens besteht darin, dass die anorganische Oxidschicht aus $SiO_x$ erzeugt wird, wobei das atomare Verhältnis von Silizium zu Sauerstoff X in einem Bereich von 1,3 bis 1,7 eingestellt wird, so dass eine anorganische Oxidschicht erzeugt wird, welche im sichtbaren Lichtwellenbereich und im nahen UV-Wellenlängenbereich für Lichtstrahlen durchlässig ist, wogegen sie diese im UV-Wellenlängenbereich bei kürzeren Wellenlängen diese absorbiert.

Das erfindungsgemäße Verfahren weist ferner den Vorteil auf, dass die Siegelschicht zwischen dem Solarzellensystem und der Barriereschicht angeordnet und vorzugsweise aus Ethylenvinylacetat (EVA) oder aus Ionomeren gebildet wird.

Erfindungsgemäß wird ferner als Kunststofffolie oder Kunststofffolienverbund, auf welcher(m) die anorganische Oxidschicht abgeschieden wird, eine Polyethylenterephthalat- (PET-) oder Ethylentetrafluoroethylencopolymer- (ETFE)-Folie eingesetzt.

Weitere Vorteile des erfindungsgemäßen fotovoltaischen Moduls bestehen darin, dass die dem Solarzellensystem zugewandte anorganische Oxidschicht mit der angrenzenden Siegelschicht direkt oder über eine Primerschicht in Kontakt steht.

Ferner kann die dem Solarzellensystem zugewandte anorganische Oxidschicht über eine zusätzliche Kunststofffolie oder Kunststofffolienverbund mit der angrenzenden Siegelschicht in Kontakt stehen. Dabei wird die anorganische Oxidschicht vorteilhafterweise über eine Kleberschicht und/oder eine Hybridschicht aus organisch-anorganischen Netzwerken mit der Kunststofffolie oder den Kunststofffolienverbund verbunden.

Die Erfindung betrifft weiters eine vorteilhafte Verfahrensvariante, welche dadurch gekennzeichnet ist, dass in einem Laminierverfahren die mit der anorganischen Oxidschicht versehene Barriereschicht zu einem Modulstapel, welcher aus dem Solarzellensystem sowie den Einkapselungsmaterialien besteht, aufgebaut wird, wobei die Siegelschichten in den Einkapselungsmaterialien das Solarzellensystem beidseitig umhüllen, dass dieser Modulstapel in eine Beladestation einer Verfahrensvorrichtung eingebracht wird, in welcher er auf eine Temperatur unterhalb der Erweichungstemperatur der Siegelschichten gehalten wird, dass der Modulstapel in einem Vakuumlaminator dieser Vorrichtung transportiert wird, welcher evakuiert wird, und in welchem der Modulstapel auf die Erweichungstemperatur der Siegelschichten erwärmt wird und dass nach dem Belüften des Vakuumlaminators ohne Rückkühlung der aus dem Modulstapel gebildete Verbund in einen Härteofen transportiert wird, in welchem die Siegelschichten ausgehärtet werden, so dass ein Laminat in Form eines fotovoltaischen Moduls gebildet wird, welches nach Rückkühlung dem kontinuierlichen Verfahrensablauf entnommen werden kann.

Kurze Beschreibung der Zeichnungen

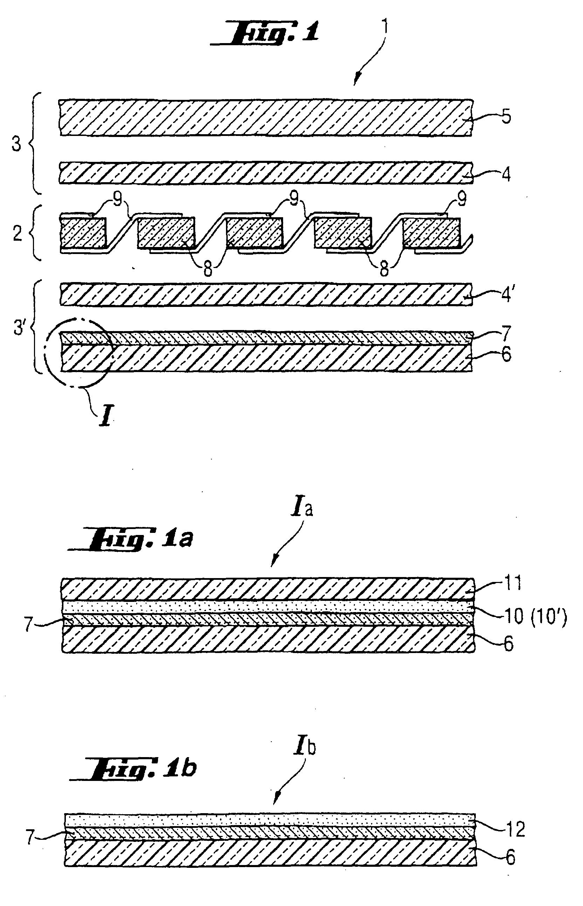

Die Erfindung wird anhand der Figuren 1 bis 4 beschrieben:

Fig. 1 zeigt den Aufbau eines erfindungsgemäß hergestellten fotovoltaischen Moduls 1, welcher aus dem Solarzellensystem 2 und den das Solarzellensystem umgebenden Einkapselungsmaterialien 3, 3' besteht. Das Solarzellensystem 2 wird aus einer Reihe von Siliziumzellen 8, welche in Serie mittels Kontaktierungsdrähten 9 zu Gruppen verlötet sind, gebildet. Das Einkapselungsmaterial 3' besteht aus der Kunststoff-Siegelschicht 4' und der Kunststofffolie bzw. dem Kunststofffolienverbund 6, welche(r) an der dem Solarzellensystem 2 zugewandten Oberflächenseite die aus der Dampfphase abgeschiedene Oxidschicht 7 aufweist. Dieser Schichtaufbau ist mit I gekennzeichnet. Das Einkapselungsmaterial 3 besteht beispielsweise aus der Schicht 5, welche eine Glasschicht oder ein Kunststofffolienverbund ähnlich zu 6 sein kann, und einer Kunststoff-Siegelschicht 4.

Fig.1 a b zeigt ferner die Varianten Ia und Ib, welche den Schichtaufbau gemäß I ersetzen können.

Gemäß Variante Ia (Fig. 1a) ist die anorganische Oxidschicht 7 über eine Kleberschicht 10 und/oder eine Hybridschicht aus organisch-anorganischen Netzwerken mit einer zusätzlichen Kunststofffolie oder einem Kunststofffolienverbund 11 verbunden.

Gemäß Variante Ib (Fig 1 b) weist die anorganische Oxidschicht 7 eine zusätzliche Primerschicht 12 auf, welche in der Folge die Verbindung zu der Siegelschicht 4' darstellt.

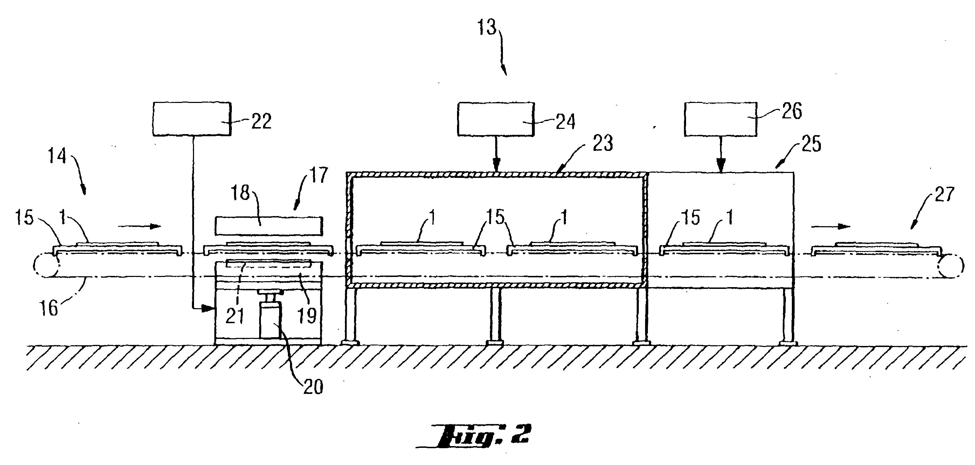

Fig. 2 zeigt eine Vorrichtung 13 zum Laminieren der in Figur 1 dargestellten Schichten für eine mögliche Durchführung des erfindungsgemäßen Verfahrens zur Herstellung des fotovoltaischen Moduls 1: Sie zeigt die Beladestation 14, an der der Modulstapel 1 auf die Trägerplatte 15, welche mittels des Transportsystems 16 bewegt wird, aufgebracht werden kann, sowie den Vakuumlaminator 17 mit dem feststehenden Oberteil 18 und dem über die Hydraulikeinrichtung 20 hebund senkbaren Unterteil 19. Temperatur, Druck und Verweilzeit werden im Vakuumlaminator 17 über das Regelungssystem 22 eingestellt. Ferner zeigt Fig. 2 den Härteofen 23, dessen Temperatur über das Regelungssystem 24 eingestellt wird, den Kühlbereich 25, dessen Temperatur über das Regelungssystem 26 einstellbar ist und den Entnahmebereich 27.

Fig. 3 zeigt die.Lichtdurchlässigkeit einer mit einer anorganischen Oxidschicht 17 bedampften Kunststofffolie 6 in unterschiedlichen Wellenlängenbereichen.

Fig. 4 zeigt inwieweit beim erfindungsgemäß hergestellten fotovoltaischen Modul 1 die Barrierewirkung gegenüber Wasserdampf durch die aus der Dampfphase im Vakuum unter Anwendung von Elektronenstrahlung abgeschiedene Oxidschicht 7 verbessert ist.

Ein Weg zur Ausführung der Erfindung:

Die Erfindung wird nunmehr anhand von Ausführungsbeispielen näher erläutert:

In einem ersten Verfahrensschritt wird die Barriereschicht 6, welche die anorganische Oxidschicht 7 aufweist, gebildet. Dabei kann der Aufbau gemäß folgender Tabelle gewählt werden, wobei die Reihenfolge von außen nach innen, das heißt in Richtung Solarzellensystem angeführt wird:

TABELLE (Beispiele a-d) :

Beispiel a

- Barriereschicht 6: Verbund aus Polyvinylfluorid (PVF) Polyethylenterephthalat (PET) in Folienform
- anorganische Oxidschicht 7 : $SiO_x$ oder $Al_2O_3$
- Siegelschicht 4'

Beispiel b

- Barriereschicht 6:
  Kunststofffolie aus Ethylentetrafluoroethylencopolymer (ETFE)
- anorganische Oxidschicht 7: $SiO_x$ oder $Al_2O_3$
- Siegelschicht 4'

Beispiel c

- Barriereschicht 6: Kunststofffolienverbund aus PVF und PET
- anorganische Oxidschicht 7: $SiO_x$ oder $Al_2O_3$
- Hybridschicht aus organisch-anorganischen Netzwerken 10'
- Kleberschicht 10: beispielsweise Polyurethan.
- Kunststofffolie oder Kunststofffolienverbund 11: Polyvinylfluorid (PVF), Polyvinylidenfluorid (PVDF), Ethylentetrafluoroethylencopolymer (ETFE), Polylethylenterephthalat (PETP)
- Siegelschicht 4'

Beispiel d

- Barriereschicht 6: Kunststofffolienverbund aus PVF und PET
- anorganische Oxidschicht 7: $SiO_x$ oder $Al_2O_3$-
- Primerschicht 12: beispielsweise Polyurethan, Ethylenvinylacetat (EVA), Polymethylmethacrylat (PMMA)
- Siegelschicht 4'

Aus der Tabelle ist zu ersehen, dass die Barriereschicht 6 gemäß Beispiel b) aus einer einzelnen Kunststofffolie und gemäß Beispiel a) aus einem Kunststofffolienverbund bestehen kann.

Als Siegelschichten 4' werden vorzugsweise Ethylenvinylazetat (EVA)-Folien, verwendet, welche bei Wärmebehandlung geringfügig fließen und in der Folge vernetzen, wodurch das Kriechen der Kunststoffe verhindert wird.

Besonders gute Siegeleigenschaften weisen Ionomere auf. Dabei handelt es sich um Polymere mit ionischen Gruppen, welche neben guten Klebeeigenschaften eine geringe Wasserdampfdurchlässigkeit zeigen.

Auf die Kunststofffolie aus PETP (s. Beispiel a) gemäß Tabelle) wird nunmehr die anorganische Oxidschicht 7 in einer Dicke von 30 bis 200 nm durch Dampfabscheidung im Vakuum (nicht dargestellt) erzeugt. Dazu wird beispielsweise eine Vakuumbeschichtungsanlage (nicht dargestellt) verwendet. Um eine zufriedenstellende Haftung zwischen der Kunststofffolienoberfläche und dem anorganischen Oxid gewährleisten zu können, wird die Oberfläche der Kunststofffolie in einem Plasma aus Sauerstoffgas (99.995% Reinheit) vorbehandelt.

Als anorganisches Beschichtungsmaterial werden beispielsweise in stöchiometrischen Mengen Aluminiumoxid (99.9% Reinheit) oder Siliziummonoxid (99.9% Reinheit) eingesetzt und unter Anwendung von Elektronenstrahlung im Vakuum verdampft. Die bei der Verdampfung angewandte Energie betrug beispielsweise 10 keV bei einer Emissionrate bis zu 220 mA. Durch Veränderung der Verdampfungsrate oder der Geschwindigkeit der über Rollen bewegten Kunststofffolien oder Kunststofffolienverbunden kann die Dicke der $SiO_x$- oder $Al_2O_3$-Schichten im Bereich von 30 bis 200 nm eingestellt werden.

So wird beispielsweise labortechnisch für die Herstellung einer 100 nm dicken $SiO_x$-Schicht eine Geschwin-

digkeit von 5 m/min gewählt, während für die Herstellung einer 40 nm dicken $Al_2O_3$-Schicht eine Geschwindigkeit von 2.5 m/min gewählt werden muß. Die Verdampfungsrate betrug dabei bis zu 70 nm/s; der beim Verdampfen angewandte Druck war etwa $5 \times 10^{-2}$Pa. Bei der industriellen Herstellung können Geschwindigkeiten eingestellt werden, die um den Faktor 100 und darüber liegen.

Die mit der anorganischen Oxidschicht versehene Kunststofffolie, beispielsweise aus PETP, kann nun zur Herstellung des Kunststofffolienverbundes mit der weiteren Kunststofffolie, beispielsweise aus PVF (s. Beispiel a) gemäß Tabelle), kaschiert werden.

Bei den erfindungsgemäßen Varianten gemäß Beispiele a) und b) ist es nun vorgesehen, dass die anorganische Oxidschicht 7 - vorzugsweise eine Siliziumoxidschicht - in direktem Kontakt mit der Siegelschicht 4' steht, wobei eine zufriedenstellende Haftvermittlung gewährleistet ist. In diesem Fall kann das atomare Verhältnis zwischen Silizium und Sauerstoff beliebig variiert werden.

Soll jedoch im erfindungsgemäßen fotovoltaischen Modul durch die anorganische Oxidschicht, vorzugsweise die Silizium-Oxidschicht, zusätzlich eine UV-Filterwirkung gewährleistet sein, so ist es notwendig, das atomare Verhältnis Silizium zu Sauerstoff beim Verdampfen derart zu steuern, dass der Anteil an Sauerstoff x zwischen 1,3 und 1,7 liegt.

Dies kann neben den vorgenannten Kriterien, wie beispielsweise Auswahl im stöchiometrischen Mengenverhältnis der Ausgangsprodukte oder der Geschwindigkeit beim Verdampfen, auch dadurch geschehen, dass zusätzlich Sauerstoff in Form eines reaktiven Gases beim Verdampfen zugeleitet wird. Es entsteht nunmehr eine im sichtbaren Lichtwellenlängenbereich hoch transparente Oxidschicht, welche dennoch UV-Strahlen absorbiert, wodurch die UV-sensiblen Siegelschichten 4' zusätzlich geschützt werden.

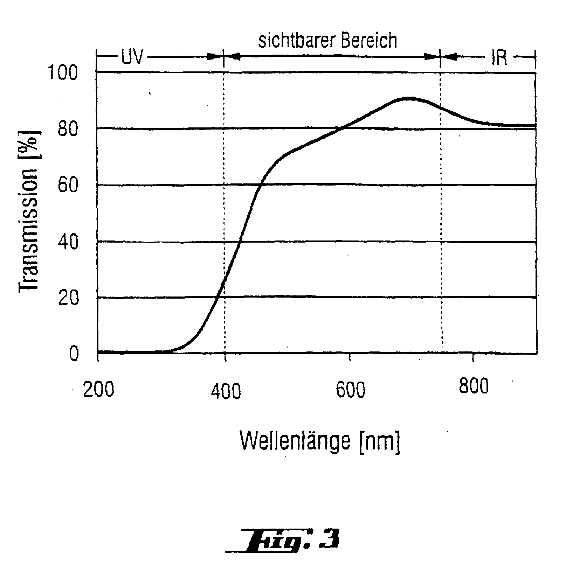

Dies wird anhand Figur 3 näher erläutert.

Gemäß Figur 3 wird die Lichtdurchlässigkeit einer Kunststofffolie aus ETFE, welche als anorganische Oxidschicht eine $SiO_x$-Schicht in einer Dicke von 320 nm aufweist, gezeigt. Daraus erkennt man, dass im UV-Bereich unterhalb 350 nm Lichtwellenlänge die mit $SiO_x$ beschichtete Kunststofffolie für Licht praktisch undurchlässig ist. Eine unbeschichtete Kunststofffolie gleicher Konstitution (nicht dargestellt) würde in diesem Bereich jedoch noch Licht absorbieren. Ab 350 nm Lichtwellenlänge beginnt die mit $SiO_x$ beschichtete ETFE-Folie das einfallende Licht durchzulassen. Eine signifikante Transparenz ist ab etwa 450 nm im blauvioletten Teil des Spektrums des sichtbaren Lichts zu bemerken. Über den weiteren sichtbaren Lichtbereich beobachtet man eine hohe Transmission, die sich erst wieder im infraroten Bereich reduziert.

Um nun die Eigenschaften des erfindungsgemäßen fotovoltaischen Moduls, wie hohe Lichttransmission im sichtbaren und im nahen UV-Bereich bei gleichzeitiger Lichtsperrwirkung im kürzerwelligen UV-Bereich und zusätzlich eine hohe Barrierewirkung gegenüber Wasserdampf zu erhalten, stehen folgende Freiheitsgrade zur Verfügung:

Variation der Dicke der anorganischen Oxidschicht:

Hierbei kann in guter Näherung nach dem Lambert-Beer'schen Gesetz

$$\ln(I/I_o) = -4\pi kd\lambda^{-1}$$

mit

I = durchgelassene Intensität des Lichts,
$I_o$ = eingestrahlte Intensität,
k = Wellenlängen-abhängiger Absorptionskoeffizient,
d = Schichtdicke der aufgedampften anorganischen Oxidschicht,
$\lambda$ = Lichtwellenlänge,

die Lichtdurchlässigkeit vorteilhafterweise beeinflußt werden.

2. Variation des Sauerstoffgehalts (x) in der anorganischen Oxidschicht, vorzugsweise $SiO_x$-Schicht:

Verschiebt man x - gemäß Fig. 3 mit einem Wert von 1.3 - durch andere Aufdampfbedingungen zu höheren Werten, so liegt die Transmission des Materials um den Wellenlängenbereich von 400 nm höher, ohne die Schichtdicke ändern zu müssen.

Durch Sauerstoffzugabe unter gleichzeitiger Einkoppelung von elektromagnetischer Energie in Form von Mikrowellenstrahlung lassen sich Werte für x, beispielsweise von etwa 1.7 einstellen.

Somit gestattet eine Variation der Parameter Schichtdicke und Sauerstoffgehalt die gleichzeitige Optimierung der Werte für die Transmission im sichtbaren Lichtbereich, die Sperrwirkung im ultravioletten Lichtbereich und die Sperrwirkung gegenüber Wasserdampf.

Ferner wird für die Außenanwendung des erfindungsgemäßen fotovoltaischen Moduls die Witterungsbeständigkeit neben dem gezielten atomaren Verhältnis Silizium zu Sauerstoff auch dadurch gewährleistet, dass die anorganische Oxidschicht 7 beidseitig von Kunststofffolien oder Kunststofffolienverbunden umhüllt sein kann.

Dies erfolgt beispielsweise gemäß Fig.1, Variante Ia dadurch, dass die Barriereschicht 6 die anorganische Oxidschicht 7 aufweist, welche wiederum über die Kleberschicht 10 mit einer weiteren Kunststofffolie oder Kunststofffolienverbund 11 in Verbindung steht. Die Kleberschicht 10 kann dabei allein oder in Kombination mit einer Schicht 10' aus Hybridschichten aus organisch-anorganischen Netzwerken vorgesehen sein. Diese Netzwerke sind anorganisch-organische Hybridsysteme auf Basis von beispielsweise Alkoxysiloxanen. Sie zeigen eine nahe Vernetzungsdichte sowie eine hohe Sperrwirkung gegenüber Wasserdampf und haften gleichzeitig zufriedenstellend auf der $SiO_x$-Schicht.

Ferner können die Kunststofffolien gemäß Beispiel c) aus der Tabelle entsprechend ausgewählt werden, so dass sie eine weitere Schutzfunktion des Solarzellensystems gegen Witterungseinflüsse übernehmen. Dabei kann die Anordung zum Solarzellensystem gemäß Fig.1/Ia auch derart gewählt werden, dass die Barriereschicht 6 an die Siegelschicht 4' anschließt, während die Kunststofffolie oder der Kunststoff-Folienverbund 11 die äußerste Lage im Modulstapel bildet.

Ferner ist es auch möglich, eine zufriedenstellende Witterungsbeständigkeit durch Maßgabe einer Primerschicht 12 aus Kunststoff zu bewirken, welche gemäß Fig 1/Var. Ib sowie Beispiel d) aus der Tabelle zwischen der Siegelschicht 4' und der anorganischen Oxidschicht 7 angeordnet ist.

Sämtliche Varianten können nunmehr in das Laminierverfahren mit Hilfe der Vorrichtung 13 gemäß Fig.2 eingesetzt werden, um den fotovoltaischen Modul 1 auszubilden.

Es wird beispielhaft, jedoch nicht einschränkend, eine Variante herausgegriffen:

Dabei wird die mit der anorganischen Schicht 7 versehene Barriereschicht 6 mit der Kunststoff-Siegelschicht 4', dem Solarzellensystem 2, einer weiteren Kunststoff-Siegelschicht 4 sowie der Glasschicht 5, wie in Fig. 1 dargestellt, verschlichtet. Anstelle der Glasschicht 5 kann ebenso ein PET/PVF-Kunststofffolienverbund eingesetzt werden.

Ferner soll die Schicht 5, insbesondere bei der Außenanwendung witterungsbeständig und dekorativ sein, so dass beispielsweise dekorative, mit einer Acrylatschicht versehene Schichtpreßstoffplatten mit der Bezeichnung MAX® EXTERIOR geeignet sind.

Dieser Modulstapel wird nun zum Laminieren in die Vorrichtung 13 gemäß Figur 2 eingebracht. Dabei wird der Modulstapel 1 an der Beladestation 14 auf die Trägerplatte 15 gelegt, welche auf Raumtemperatur jedoch maximal auf einer Temperatur von 80°C gehalten wird.

An seiner Ober- und Unterseite ist der Modulstapel mit Trennfolien (nicht dargestellt) versehen, um eine Haftung an der Trägerplatte 15 sowie an den übrigen Anlagenteilen zu vermeiden.

Nach der Aufgabe des Modulstapels 1 auf die Trägerplatte 15 wird diese über das Transportsystem 16, beispielsweise einen Kettenförderer, in den Vakuumlaminator 17 befördert. Die Temperatur der Heizplatte 21 wird darin über ein externes Regelungssystem 22 auf einer Temperatur entsprechend der Erweichungstemperatur der in der Siegelschicht eingesetzten Kunststoffmaterialien gehalten. Durch die Hydraulikvorrichtung 20 wird die Heizplatte 21 gegen die Trägerplatte 15 gedrückt, so dass - bedingt durch den Wärmestrom innerhalb der Trägerplatte - die Kunststoff-Siegelschichten 4, 4' im Modulstapel auf ihre Erweichungstemperatur gebracht werden.

Nach dem Schließen des Laminators 17 wird über die externe Regelungseinrichtung 22 ein Vakuum angelegt. Durch die Evakuierung werden Luft und sonstige volatile Bestandteile aus dem Modulstapel entfernt, so dass ein blasenfreies Laminat gewährleistet ist. Anschließend wird belüftet, wodurch die flexible Membran (nicht dargestellt) an den Modulstapel gepreßt wird.

Nach einer definierten Verweilzeit des Modulstapels 1 im Vakuumlaminator 17 wird dieser belüftet und der Modulstapel ohne weiteren Preßdruck in den Härteofen 23 transportiert. Darin wird dieser bedingt durch das Regelungssystem 24 auf einer definierten Temperatur gehalten, so dass die Siegelschichten im Modulstapel während einer definierten Verweilzeit aushärten und ein Laminat gebildet wird, welches anschließend im Kühlbereich 25 auf Raumtemperatur gekühlt wird. Das ausgehärtete Laminat wird. im Entnahmebereich 27 von der Trägerplatte abgenommen und die rückgekühlte Trägerplatte kann zur Beladestation 14 rückgeführt werden.

Das erfindungsgemäß hergestellte fotovoltaische Modul 1 kann als Solarzellensystem 2 anstelle der kristallinen Siliziumzellen auch sogenannte Dünnschicht-Solarzellen aufweisen. In diesem Fall kann das Solarzellensystem mit den Einkapselungsmaterialien 3,3' beispielsweise mittels Verpressen oder Kalandrieren verbunden werden. Diese Dünnschichtsolarzellen sind zwar nicht bruchempfindlich, jedoch wasserempfindlich, so dass sich der erfindungsgemäße Lösungsvorschlag besonders anbietet.

Der fotovoltaische.Modulstapel kann beispielsweise folgenden Aufbau haben:

| Beispiel e): | |
|---|---|
| Schicht 5 | Glas |
| Solarzellensystem 2 | Dünnschichtsolarzelle aus amorphem Silizi um |
| Siegelschicht 4' | EVA |

(fortgesetzt)

| Beispiel e): | |
|---|---|
| Barriereschicht 6 | aus ETFE-Kunststofffolie mit anorganischer |
| Oxidschicht 7 | aus $SiO_x$ |

| Beispiel f) | |
|---|---|
| Schicht 5 | Glas |
| Solarzellensystem 2 | Dünnschichtsolarzelle aus Cadmiumtellurid |
| Siegelschicht 4' | EVA |
| Barriereschicht 6 | Kunststofffolienverbund aus PVF/PET und anorganischer Oxidschicht 7 aus $SiO_x$ |

In den Beispielen gemäß e) und f) wird das Dünnschichtsolarzellensystem durch die Barriereschicht 6 gegen Wasserdampf geschützt. Da jedoch diese nicht bruchempfindlich ist, kann die zusätzliche Siegelschicht 4 wegfallen.

Gewerbliche Anwendbarkeit

Die durch das erfindungsgemäße Verfahren hergestellten fotovoltaischen Module dienen zur elektrischen Energieerzeugung aus Sonnenlicht. Ihre Anwendungsmöglichkeiten sind vielfältig und reichen von Kleinenergieanlagen für Notrufsäulen oder Wohnmobile über Gebäude integrierte Dach- und Fassadenanlagen bis hin zu Großanlagen und Solarkraftwerken.

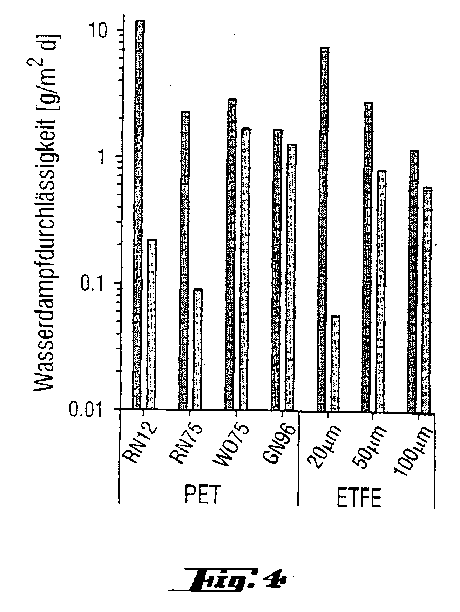

Bei den Anwendungen im Außenbereich hat es sich gezeigt, dass die Barrierewirkung gegenüber Wasserdampf durch die aus der Dampfphase abgeschiedene Oxidschicht wesentlich verbessert wird. Dies wird gemäß Figur 4 näher erläutert.

Dabei wurden unbeschichtete Folien (linker Balken auf der Abszisse) mit $SiO_x$-beschichteten Folien (rechter Balken auf der Abszisse) hinsichtlich ihrer Wasserdampfdurchlässigkeit in $g/m^2d$ verglichen.

Bei diesem Vergleich ist zu ersehen, dass im Falle von PET der Type RN 12 die Wasserdampfdurchlässigkeit auf etwa ein Zehntel des Wertes des unbeschichteten Materials reduziert werden konnte, im Falle der Type RN 75 auf 1/25. Für ETFE mit einer Materialstärke von 20 μm wird die Wasserdampfdurchlässigkeit sogar um etwa den Faktor 100 herabgesetzt.

**Patentansprüche**

1.    Verfahren zur Herstellung eines fotovoltaischen Moduls (1) in Form eines Laminates, bestehend aus einem Solarzellensystem (2) als Kernschicht, sowie beidseitig an diese angebrachten Einkapselungsmaterialien (3, 3'), wobei zumindest ein Einkapselungsmaterial (3') aus einer Siegelschicht (4') und einer Barriereschicht (6) besteht, **dadurch gekennzeichnet, dass** die Barriereschicht (6) aus einer Kunststofffolie oder einem Kunststofffolienverbund gebildet wird, auf welcher(m) an der dem Solarzellensystem (2) zugewandten Seite eine anorganische Oxidschicht (7) durch Dampfabscheidung im Vakuum unter Anwendung von Elektronenstrahlung hergestellt wird.

2.    Verfahren nach Anspruch 1, **dadurch gekennzeichnet, dass** zur Verbesserung der Haftung zwischen Kunststofffolienoberfläche und anorganischer Oxidschicht die Oberfläche der Kunststofffolie in einem Plasma aus Sauerstoffgas vorbehandelt wird.

3.    Verfahren nach Anspruch 1 oder 2, **dadurch gekennzeichnet, dass** die anorganische Oxidschicht (7) aus den Elementen Aluminium oder Silicium in einer Dicke von 30 bis 200 nm ausgebildet wird.

4.    Verfahren nach einem der Ansprüche 1 bis 3, **dadurch gekennzeichnet, dass** die anorganische Oxidschicht (7) aus $SiO_x$ gebildet wird, wobei das atomare Verhältnis X von Silizium zu Sauerstoff in einem Bereich von 1,3 bis 1,7 eingestellt wird, so dass die anorganische Oxidschicht (7) im sichtbaren Lichtwellenbereich und im nahen UV-Wellenlängenbereich für Lichtstrahlen durchlässig ist, wogegen sie diese im UV-Wellenlängenbereich bei kürzeren Wellenlängen absorbiert.

5.    Verfahren nach einem der Ansprüche 1 bis 4, **dadurch gekennzeichnet, dass** die Siegelschicht (4') zwischen dem Solarzellensystem (2) und der Barriereschicht (6) angeordnet wird.

6.  Verfahren nach Anspruch 5, **dadurch gekennzeichnet, dass** die Siegelschicht (4') aus Ethylenvinylacetat (EVA) gebildet wird.

7.  Verfahren nach Anspruch 5, **dadurch gekennzeichnet, dass** die Siegelschicht (4') aus Ionomeren gebildet wird.

8.  Verfahren nach einem der Ansprüche 1 bis 7, **dadurch gekennzeichnet, dass** die Kunststofffolie oder Kunststofffolienverbund, auf welcher(m) die anorganische Oxidschicht abgeschieden wird, entweder aus Polyethylenterephthalat (PET) oder Ethylentetrafluoroethylencopolymer (ETFE) oder aus dem Verbund aus Polyvinylfluorid (PVF) und Polyethylenterephthalat (PET) besteht.

9.  Verfahren nach einem der Ansprüche 1 bis 8, **dadurch gekennzeichnet, dass** die dem Solarzellensystem (2) zugewandte anorganische Oxidschicht (7) in direktem Kontakt mit der angrenzenden Siegelschicht (4') steht.

10. Verfahren nach einem der Ansprüche 1 bis 8, **dadurch gekennzeichnet, dass** die dem Solarzellensystem (2) zugewandte anorganische Oxidschicht (7) über eine Primerschicht (12) mit der angrenzenden Siegelschicht (4') in Kontakt steht.

11. Verfahren nach einem der Ansprüche 1 bis 8, **dadurch gekennzeichnet, dass** die dem Solarzellensystem (2) zugewandte anorganische Oxidschicht (7) über eine zusätzliche Kunststofffolie oder Kunststofffolienverbund (11) mit der angrenzenden Siegelschicht (4') in Kontakt steht.

12. Verfahren nach Anspruch 11, **dadurch gekennzeichnet, dass** die anorganische Oxidschicht (7) über eine Kleberschicht (10) und/oder eine Hybridschicht aus organisch-anorganischen Netzwerken (10') mit der Kunststofffolie oder den Kunststofffolienverbunden (11) verbunden wird.

13. Verfahren nach einem der Ansprüche 1 bis 12, **dadurch gekennzeichnet, dass** in einem Laminierverfahren die mit der anorganischen Oxidschicht (7) versehene Barriereschicht (6) zu einem Modulstapel (1), welcher aus dem Solarzellensystem (2) sowie den Einkapselungsmaterialien (3,3') besteht, aufgebaut wird, wobei die Siegelschichten (4,4') in den Einkapselungsmaterialien das Solarzellensystem (2) beidseitig umhüllen, dass dieser Modulstapel in eine Beladestation (14) einer Vorrichtung (13) eingebracht wird, in welcher er auf eine Temperatur unterhalb der Erweichungstemperatur der Siegelschichten (4,4') gehalten wird, dass der Modulstapel in einen Vakuumlaminator (17) dieser Vorrichtung (13) trahsportiert wird, welcher evakuiert wird, und in welchem der Modulstapel auf die Erweichungstemperatur der Siegelschichten (4,4') erwärmt wird und dass nach dem Belüften des Vakuumlaminators (17) ohne Rückkühlung der aus dem Modulstapel gebildete Verbund in den Härteofen (23) transportiert wird, in welchem die Siegelschichten (4,4') ausgehärtet werden, so dass ein Laminat (2) in Form eines fotovoltaischen Moduls gebildet wird, welches nach Rückkühlung dem kontinuierlichen Verfahrensablauf entnommen werden kann.

## Claims

1.  Method for producing a photovoltaic module (1) in the form of a laminate, comprising a solar cell system (2) as core layer, and encapsulation materials (3, 3'), which are applied on the latter on both sides, at least one encapsulation material (3') comprising a sealing layer (4') and a barrier layer (6), **characterised in that** the barrier layer (6) is formed from a plastic material film or a plastic material film composite, on which an inorganic oxide layer (7) is produced on the side orientated towards the solar cell system (2) by vapour deposition in a vacuum using electron emission.

2.  Method according to claim 1, **characterised in that**, in order to improve the adhesion between plastic material film surface and inorganic oxide layer, the surface of the plastic material film is pretreated in a plasma made of oxygen gas.

3.  Method according to claim 1 or 2, **characterised in that** the inorganic oxide layer (7) is formed from the elements aluminium or silicon at a thickness of 30 to 200 nm.

4.  Method according to one of the claims 1 to 3, **characterised in that** the inorganic oxide layer (7) is formed from

$SiO_x$, the atomic ratio X of silicon to oxygen being set in a range of 1.3 to 1.7 so that the inorganic oxide layer (7) is transparent in the visible light wave range and in the near UV wavelength range for light beams, whereas it absorbs these in the UV wavelength range in the case of shorter wavelengths.

5. Method according to one of the claims 1 to 4, **characterised in that** the sealing layer (4') is disposed between the solar cell system (2) and the barrier layer (6).

6. Method according to claim 5, **characterised in that** the sealing layer (4') is formed from ethylene vinyl acetate (EVA).

7. Method according to claim 5, **characterised in that** the sealing layer (4') is formed from ionomers.

8. Method according to one of the claims 1 to 7, **characterised in that** the plastic material film or plastic material film composite, on which the inorganic oxide layer is deposited, comprises either polyethylene terephthalate (PET) or ethylenetetrafluoroethylene copolymer (ETFE) or the composite of polyvinylfluoride (PVF) and polyethylene terephthalate (PET).

9. Method according to one of the claims 1 to 8, **characterised in that** the inorganic oxide layer (7) orientated towards the solar cell system (2) is in direct contact with the adjacent sealing layer (4').

10. Method according to one of the claims 1 to 8, **characterised in that** the inorganic oxide layer (7) orientated towards the solar cell system (2) is in contact with the adjacent sealing layer (4') via a primer layer (12).

11. Method according to one of the claims 1 to 8, **characterised in that** the inorganic oxide layer (7) orientated towards the solar cell system (2) is in contact with the adjacent sealing layer (4') via an additional plastic material film or plastic material film composite (11).

12. Method according to claim 11, **characterised in that** the inorganic oxide layer (7) is connected to the plastic material film or to the plastic material film composites (11) via an adhesive layer (10) and/or a hybrid layer made of organic-inorganic networks (10').

13. Method according to one of the claims 1 to 12, **characterised in that**, in a laminating process, the barrier layer (6) provided with the inorganic oxide layer (7) is built-up into a module stack (1) which comprises the solar cell system (2) and the encapsulation materials (3, 3'), the sealing layers (4, 4') in the encapsulation materials covering the solar cell system (2) on both sides, **in that** this module stack is introduced into a loading station (14) of a device (13) in which said stack is maintained at a temperature below the softening temperature of the sealing layers (4, 4'), **in that** the module stack is transported into a vacuum laminator (17) of this device (13), which is evacuated and in which the module stack is heated to the softening temperature of the sealing layers (4, 4'), and **in that**, after aerating the vacuum laminator (17) without cooling down, the composite formed from the module stack is transported into the curing furnace (23) in which the sealing layers (4, 4') are cured so that a laminate (2) is formed in the form of a photovoltaic module which, after cooling down, can be removed from the continuous method process.

**Revendications**

1. Procédé de fabrication d'un module photovoltaïque (1) présentant la forme d'un stratifié constitué d'un système de cellules solaires (2), en tant que couche de coeur, et de matériaux d'encapsulation (3, 3') appliqués sur les deux faces de ce système, au moins l'un de ces matériaux d'encapsula-tion (3') étant constitué d'une couche de scellage (4') et d'une couche bar-rière (6), **caractérisé en ce que** cette couche barrière (6) est formée d'une feuille de matière plastique ou d'un composite de feuilles de matières plas-tiques sur laquelle ou lequel on forme, du côté tourné vers le système de cellules solaires (2), une couche d'oxyde inorganique (7), par dépôt sous vide à partir d'une phase vapeur, effectué à l'aide de faisceaux d'électrons.

2. Procédé conforme à la revendication 1, **caractérisé en ce que**, pour améliorer l'adhérence entre la surface de la feuille de matière plastique et la couche d'oxyde inorganique, on traite au préalable la surface de la feuille de matière plastique à l'aide d'un plasma à base d'oxygène gazeux.

3. Procédé conforme à la revendication 1 ou 2, **caractérisé en ce que** la couche d'oxyde inorganique (7) contient de l'aluminium ou du silicium et présente une épaisseur de 30 à 200 nm.

4. Procédé conforme à l'une des revendications 1 à 3, **caractérisé en ce que** la couche d'oxyde inorganique (7) est constituée d'oxyde SiO$_x$ où le rapport atomique x du silicium à l'oxygène vaut de 1,3 à 1,7, de sorte que la couche d'oxyde inorganique (7) laisse passer les rayons lumineux de longueurs d'onde situées dans les domaines visible et proche UV, mais absorbe ceux de longueur d'onde plus courte dans le domaine UV.

5. Procédé conforme à l'une des revendications 1 à 4, **caractérisé en ce que** la couche de scellage (4') se trouve entre le système de cellules solaires (2) et la couche barrière (6).

6. Procédé conforme à la revendication 5, **caractérisé en ce que** la couche de scellage (4') est en éthylène-acétate de vinyle (EVA).

7. Procédé conforme à la revendication 5, **caractérisé en ce que** la couche de scellage (4') est en ionomère.

8. Procédé conforme à l'une des revendications 1 à 7, **caractérisé en ce que** la feuille de matière plastique ou le composite de feuilles de matières plastiques sur laquelle ou lequel est déposée la couche d'oxyde inorganique est soit en polyéthylènetéréphtalate (PET) ou en copolymère d'éthylène et de tétrafluoroéthylène (ETFE), ou un composite de fluorure de polyvinyle (PVF) et de polyéthylènetéréphtalate (PET).

9. Procédé conforme à l'une des revendications 1 à 8, **caractérisé en ce que** la couche d'oxyde inorganique (7) se trouve, du côté tourné vers le système de cellules solaires (2), en contact direct avec la couche de scellage (4') adjacente.

10. Procédé conforme à l'une des revendications 1 à 8, **caractérisé en ce que** la couche d'oxyde inorganique (7) se trouve, du côté tourné vers le système de cellules solaires (2), en contact avec la couche de scellage (4') adjacente par l'intermédiaire d'une couche de primaire (12).

11. Procédé conforme à l'une des revendications 1 à 8, **caractérisé en ce que** la couche d'oxyde inorganique (7) se trouve, du côté tourné vers le système de cellules solaires (2), en contact avec la couche de scellage (4') adjacente par l'intermédiaire d'une feuille de matière plastique ou d'un composite de feuilles de matières plastiques supplémentaire (11).

12. Procédé conforme à la revendication 11, **caractérisé en ce que** la couche d'oxyde inorganique (7) est connectée à la feuille de matière plastique ou au composite de feuilles de matières plastiques (11) par l'intermédiaire d'une couche d'adhésif (10) et/ou d'une couche hybride (10') en réseaux organiques-inorganiques.

13. Procédé conforme à l'une des revendications 1 à 12, **caractérisé en ce que**, dans un procédé de stratification, on monte la couche barrière (6) munie de la couche d'oxyde inorganique (7) dans un empilement modulaire (1) constitué du système de cellules solaires (2) et des matériaux d'encapsulation (3, 3'), les couches de scellage (4, 4') des matériaux d'encapsulation entourant le système de cellules solaires (2) sur ses deux faces, **en ce que** l'on amène cet empilement modulaire au poste de charge (14) d'un dispositif (13), dans lequel on le maintient à une température inférieure à la température de ramollissement des couches de scellage (4, 4'), **en ce que** l'on transporte l'empilement modulaire jusque dans une enceinte de stratification sous vide (17) du dispositif (13), dans laquelle on fait le vide et l'on chauffe l'empilement modulaire pour le porter à la température de ramollissement des couches de scellage (4, 4'), et **en ce que**, après avoir laissé de l'air rentrer dans l'enceinte de stratification sous vide (17), on transfère le stratifié formé à partir de l'empilement modulaire, sans le laisser ni le faire refroidir, dans un four de durcissement (23) dans lequel on fait durcir les couches de scellage (4, 4'), de manière à obtenir un stratifié (2) qui est un module photovoltaïque et qui, après refroidissement, peut être retiré et ainsi soustrait au déroulement continu du procédé.

**Fig. 1**

**Fig. 1a**

**Fig. 1b**

Fig. 2

*Fig. 3*

*Fig. 4*